# EUROPÄISCHE PATENTSCHRIFT

(11) **EP 2 511 229 B1**
(45) Veröffentlichungstag und Bekanntmachung des Hinweises auf die Patenterteilung: **08.03.2017**
(21) Anmeldenummer: 11003088.9
(22) Anmeldetag: 12.04.2011
(51) Int. Cl.: G04B 13/02, G04B 17/06, G04B 31/004, B81C 1/00, B81B 3/00, G04B 1/14, G04B 15/14

(54) **Flankenverstärktes mikromechanisches Bauteil**
Micromechanical component with reinforced flanks
Composant micromécanique doté de flancs renforcés

(43) Veröffentlichungstag der Anmeldung: 17.10.2012
(73) Patentinhaber: GFD Gesellschaft für Diamantprodukte mbH, 89081 Ulm (DE); Diamaze Microtechnology S.A., 2300 La Chaux-de-Fonds (CH)
(72) Erfinder: Gluche, Peter, 89287 Bellenberg (DE); Gretzschel, Ralph, 89231 Neu-Ulm/Offenhausen (DE); Wiora, Matthias, 89134 Blaustein (DE)
(74) Vertreter: Pfenning, Meinig & Partner mbB

(56) Entgegenhaltungen:
- EP-A1- 2 236 455
- DE-A1-102008 041 778
- DE-A1-102008 061 182
- SMALLWOOD S A ET AL: "Performance results of MEMS coated with a conformal DLC", WEAR, ELSEVIER SEQUOIA, LAUSANNE, CH, vol. 260, no. 11-12, 30 June 2006 (2006-06-30), pages 1179-1189, XP027902519, ISSN: 0043-1648 [retrieved on 2006-06-30]

## Beschreibung

Die Erfindung betrifft ein mikromechanisches Bauteil, das aus einem Trägermaterial mit einer Ober- und einer Unterseite sowie mindestens zwei Seitenflächen besteht und einer das Trägermaterial umgebenden Beschichtung, wobei die Beschichtung aus Diamant und/oder diamantartigem Kohlenstoff gebildet ist. Das mikromechanische Bauteil nach der Erfindung zeichnet sich dadurch aus, dass die Beschichtung aus Diamant und/oder diamantartigem Kohlenstoff zumindest auf mindestens einer Seitenfläche des mikromechanischen Bauteils eine kleinere Schichtdicke aufweist als auf der Ober- und/oder Unterseite des Bauteils, so dass ein verstärkter Bereich entsteht.

Verbundwerkstoffe aus einem Trägermaterial und Diamant sind bekannt. So beschreibt z.B. die deutsche Offenlegungsschrift DE 10 2004 052 068 A1 ein Schneidwerkzeug und ein Verfahren zu seiner Herstellung, bei dem auf ein Trägermaterial, das z.B. metallisch ist, eine Beschichtung aus Diamant aufgebracht ist. Im Stand der Technik sind auch mikromechanische Bauteile bekannt, die aus einem Trägermaterial bestehen, das vollflächig mit einer Schicht aus Diamant bzw. aus DLC ummantelt sind. So beschreibt die DE 10 2008 041 778 A1 eine Zugfeder für ein Federhaus eines Uhrwerks, wobei diese Zugfeder aus einem Trägermaterial, wie z.B. Silizium, besteht und dass dieses Trägermaterial vollflächig mit einer Schicht aus Diamant bzw. DLC ummantelt ist.

Bei dem im Stand der Technik bisher bekannten mikromechanischen Bauteilen, so z.B. auch bei der Zugfeder nach der DE 10 2008 041 778 A1, wird auf das Trägermaterial, das nach der vorstehend genannten Offenlegungsschrift im Querschnitt rechteckig ausgebildet ist, eine Diamantschicht aufgebracht, die das Trägermaterial vollflächig umgibt und dabei überall die gleiche Dicke aufweist Die Patentschrift EP 2 236 455 A1 beschreibt eine weitere mikromechanisches Bauteil, die eine Diamantbeschichtung umfasst.

Bei den im Stand der Technik beschriebenen Bauteilen werden insbesondere die überragenden physikalischen Eigenschaften von Diamant, wie seine extrem hohe Härte und seine guten Gleitreibeigenschaften ausgenutzt.

Nachteilig bei diesen vorbekannten mikromechanischen Bauteilen ist allerdings, dass das Bauteil nicht optimal an seinen Anwendungsfall bzw. Belastungsfall anpassbar ist, da z.B. im Falle der Zugfeder die Kräfte, die auf die Zugfeder einwirken, über die gesamte Länge der Feder nicht konstant sind, so dass dadurch noch kein optimales Gangverhalten erreicht werden kann. Das gleiche gilt auch für andere Bauteile, die mit einer Diamantschicht versehen sind und in Kontakt mit anderen Bauteilen stehen, da die Kräfte hier nur punktuell, z.B. an den Kontaktpunkten, einwirken. Dies gilt u.a. für Anker und Ankerrad aber auch für alle Räderwerks und Lagerbauteile.

Ausgehend hiervon ist es deshalb die Aufgabe der vorliegenden Erfindung, mikromechanische Bauteile vorzuschlagen, die so ausgebildet sind, dass sie an ihren Einsatzzweck in Bezug auf die geforderten physikalischen und mechanischen Eigenschaften, d.h. den spezifischen mechanischen Belastungsfall optimal anpassbar sind. Gleichzeitig sollte das mikromechanische Bauteil kostengünstig herstellbar sein. Im Fall von Uhrenbauteilen sollte das Bauteil darüber hinaus leicht sein (geringe Masse bzw. geringes Trägheitsmoment) und eine beliebig komplex geformte Geometrie realisierbar sein.

Die Aufgabe wird in Bezug auf das mikromechanische Bauteil durch die Merkmale des Patentanspruchs 1 und in Bezug auf das Herstellungsverfahren durch die Merkmale der Patentansprüche 11 gelöst.

Die Unteransprüche zeigen vorteilhafte Weiterbildungen auf.

Erfindungsgemäß wird somit vorgeschlagen, ein mikromechanisches Bauteil mit einer Ober- und Unterseite sowie aus einem mindestens zwei Seitenflächen aufweisenden Trägermaterial mit einer die Flächen des Trägermaterials umgebenden Beschichtung aus Diamant und/oder diamantartigem Kohlenstoff (DLC) zu versehen, so dass eine dreidimensionale Beschichtung vorliegt. Kernpunkt der erfindungsgemäßen Lehre ist nun, dass die Beschichtung aus Diamant und/oder aus DLC so ausgebildet ist, dass sie auf mindestens einer Seitenfläche des Bauteils über mindestens einen Teil dieser Seitenfläche gegenüber der Ober- und/oder Unterseite eine kleinere Schichtdicke besitzt, so dass auf der mindestens einen Seitenfläche die Schichtdicke variiert. Dadurch entstehen lokal auf mindestens einer dieser Seitenflächen verstärkte Bereiche. Im Ergebnis liegt somit eine Modulation der Beschichtung auf der mindestens einen Seitenfläche vor.

Die Diamantschicht, die erfindungsgemäß beim Bauteil eingesetzt wird, ist dabei bevorzugt eine mikro- und/oder nanokristalline Diamantschicht. Vorteilhafte mittlere Korngrößen liegen im Bereich zwischen 5 und 100 nm, ganz besonders bevorzugt im Bereich zwischen 1 und 10 nm. Erfindungsgemäß wird unter nanokristallinem Diamant eine Diamantschicht verstanden, wobei die kristallinen Domänen eine mittlere Korngröße d₅₀ von ≤ 100 nm aufweisen. Diese Definition bedingt, dass zumindest bei 50 % der Kristallite jede Dimension eines einzelnen Kristallite ≤ 500 nm ist. Die nanokristalline Diamantschicht zeichnet sich somit im Gegensatz zu polykristallinen Diamantschichten durch eine äußerst hohe Homogenität der Kristallite aus.

Weiter ist bevorzugt, wenn der in Richtung der Dicke der nanokristallinen Diamantschicht gemessene Gradient der mittleren Korngröße des nanokristallinen Diamants < 300 %, bevorzugt < 100 %, besonders bevorzugt < 50 % beträgt. Diese Ausführungsform sieht vor, dass der mittlere Korngrößendurchmesser der nanokristallinen Domänen der Diamantschicht durch die gesamte Schichtdicke hindurch relativ gleichmäßig bis besonders gleichmäßig verteilt ist, d.h. die Korngrößen sind auf der einen Seite der Diamantschicht ca. gleich groß wie auf der anderen Seite der Diamantschicht; besonders vorteilhaft ist dabei natürlich eine nahezu oder eine vollständig komplette Homogenität der nanokristallinen Domänen der Diamantschicht. Der Gradient wird dadurch bestimmt, dass der mittlere Korngrößendurchmesser d₅₀ auf einer Seite der Diamantschicht ermittelt wird und in Bezug zum mittleren Korngrößendurchmesser auf der gegenüber liegenden Seite der Diamantschicht gesetzt wird. Dabei kann beispielsweise die mittlere Korngrößenverteilung auf der Oberfläche der jeweiligen Diamantschicht herangezogen werden.

Eine weitere Ausführungsform sieht vor, dass der Anteil an sp- und sp²-Bindungen der feinkristallinen Diamantschicht zwischen 0,5 und 10 %, bevorzugt zwischen 2 und 9 %, besonders bevorzugt zwischen 3 und 8 % beträgt.

Eine weitere bevorzugte Ausführungsform der vorliegenden Erfindung sieht vor, dass zwischen dem Substrat und der feinkristallinen Diamantschicht optional eine Haftvermittlerschicht, bevorzugt aus Siliziumkarbid, Wolfram, Titan oder Silizium, aufgebracht bzw. in-situ gebildet wird. Diese Ausführungsform gewährleistet einen guten Halt der Diamantschicht auf dem Substrat.

Gemäß der Erfindung ist es weiterhin günstig, wenn die Kristallite der feinkristallinen Diamantschicht bevorzugt in <100>-, <110>- und/oder <111>-Richtung aufgewachsen sind, d.h. eine Textur vorliegt. Dies kann aus dem Herstellungsprozess resultieren, bei dem die Wachstumsgeschwindigkeit bestimmter Kristallrichtungen gezielt bevorzugt werden kann. Diese anisotrope Textur der Kristallite beeinflusst die mechanischen Eigenschaften ebenso positiv.

Da es unter anderem Aufgabe ist, die mechanische Stabilität des Bauteils lokal zu erhöhen, bringt die Verwendung von Diamantschichten mit derartigen Korngrößen mehrere Vorteile mit sich:

### Verringerung der Bruchanfälligkeit

Im Gegensatz zu polykristallinen Diamantschichten sind die einzelnen Körner im Falle von nanokristallinen Diamantschichten wie vorstehend erläutert sehr klein. Eine Korngrenze, welche generell eine Schwachstelle des Materials darstellt, hat damit ebenfalls sehr geringe Abmessungen, insbesondere, wenn man das Verhältnis der Korngrenzenausdehnung zur Schichtdicke der Diamantschicht betrachtet. Im Gegensatz zu polykristallinem Diamant, bei dem die Korngrenzen meist kolumnar durch die gesamte Schicht hindurch verlaufen, stellt die Korngrenze im nanokristallinen Diamant keine mikroskopische Sollbruchstelle mehr dar und die makroskopisch ermittelten Biegebruchspannungen σ₀ derartiger nanokristallliner Diamantschichten sind damit im Vergleich zu polykristallinen Diamantschichten sehr hoch. Typische Werte liegen bei > 2 GPa, bevorzugt > 4 GPa und besonders bevorzugt > 5 Pa.

Bezüglich der Definition der Biegebruchspannung wird auf die folgenden Literaturstellen verwiesen:
- R. Morrell et al., Int. Journal of Refractory Metals & Hard Materials, 28 (2010), S. 508-515;
- R. Danzer et al. in "Technische keramische Werkstoffe", herausgegeben von J. Kriegesmann, HvB Verlag, Ellerau, ISBN 978-3-938595-00-8, Kapitel 6.2.3.1 - Der 4-Kugelversuch zur Ermittlung der biaxialen Biegefestigkeit spröder Werkstoffe".

Die Biegebruchspannung wird dabei durch statistische Auswertung von Bruchversuchen z.B. im B3B-Belastungsversuch gemäß den oben stehenden Literaturangaben ermittelt. Sie ist dabei definiert als die Bruchspannung, bei der eine Bruchwahrscheinlichkeit von 63 % vorliegt.

Bessere Adhäsion (Delaminationsprophylaxe) durch Anpassung der Biegesteifigkeit an das Substrat

Die Verwendung von nanokristallinen Diamantschichten mit den wie vorstehend angegebenen Korngrößen führt dazu, dass auch das E-Modul gegenüber polykristallinen Diamantschichten deutlich erniedrigt wird, so dass eine bessere Anpassung an das E-Modul des Substrates gewährleistet ist. So weisen polykristalline Diamantschichten meist ein E-Modul von > 1000 GPa auf. Typische Substratmaterialien, wie beispielsweise Silizium oder Siliziumdioxid, besitzen einen deutlich geringeren E-modul von etwa 100 bis 200 GPa. Der großen Unterschied der Biegesteifigkeit zwischen Substrat und Beschichtung führt im mechanischen Belastungsfall zu einer starken Belastung des Interfaces, welches im schlimmsten Fall versagen kann und damit zu einer Delamination der Diamantschicht führen kann. Letzteres hat das Totalversagen des Bauteils zur Folge. Aus diesem Grund ist eine Angleichung der Biegesteifigkeit von Substrat und Beschichtung vorteilhaft. Dies kann nun ebenfalls durch eine Verringerung der Korngröße erreicht werden. Da mit abnehmender Korngröße der Diamantschicht das Korngrenzenvolumen im Verhältnis zum Kristallvolumen (Kornvolumen) zunimmt und an der Korngrenze in der Regel schwächere Bindungen als im Kristall (Korn) vorhanden sind, korreliert das makroskopisch ermittelte E-Modul diametral mit der mittleren Korngröße. Typische Werte für das E-Modul von nanokristallinen Diamantschichten (Korngröße etwa 10 nm) liegen im Bereich von < 900 GPa und ganz besonders bevorzugt < 700 GPa.

### Bessere Reibeigenschaften

Weiterhin wirkt sich die Verwendung von Diamantschichten mit mittleren Korngrößen im Bereich zwischen 5 und 100 nm und besonders bevorzugt im Bereich zwischen 1 und 10 nm vorteilhaft auf die Oberflächenrauigkeit aus, da diese ebenfalls mit abnehmender Korngröße abnimmt. Der ermittelte Gleitreibkoeffizient (z.B. ermittelt durch rotativen Reibversuch Kugel gegen Scheibe mittels eines Tribometers) zweier in Kontakt stehender Diamantschichten hängt von dessen Oberflächenrauheiten ab. Können sich die mikroskopisch vorhandenen Rauheiten miteinander Verzahnen, wird makroskopisch ein erhöhter Gleitreibkoeffizient gemessen. Dieser liegt im Bereich von etwa 0,3. Nach einiger Zeit führt der Reibkontakt zu einer Politur der Oberflächen, die im besten Fall zu einer ideal glatten Oberfläche führt. Ist dieser Zustand erreicht, werden Gleitreibkoeffizienten von 0,01 bis 0,03 gemessen. Der kleine Korndurchmesser nanokristalliner Diamantschichten wirkt sich deshalb auch direkt auf den Gleitreibkoeffizienten der Bauteile aus.

Selbstverständlich können die Oberflächen aus den Diamantschichten auch durch eine nachgelagerte Politur mechanisch nachbearbeitet werden, z.B. durch mechanisches Gleit- oder Schleppschleifen. Auch ein Ultraschall-unterstütztes Schleifen in abrasiven Suspensionen aus Diamantpartikeln oder keramischen Schleifmitteln, wie z.B. Al₂O₃ oder SiC oder o.ä., Plasmapolitur in Sauerstoff und/oder Chlor - und/oder fluorhaltigen Plasmen und/oder Ionen-unterstützte Bearbeitungsschritte, wie RIE (reactive ion etching), Ion Milling, oder andere Ionenstrahl-unterstützte Verfahren sind möglich. Dadurch wird eine vorteilhafte Oberflächenrauigkeit zwischen 1 und 50 rms, besonders vorteilhaft eine Oberflächenrauigkeit < 7 nm rms erreicht.

Durch die erfindungsgemäße Modulierung der Seitenfläche und der eingesetzten nanokristallinen Diamantschichten können die Eigenschaften des Bauteils gezielt beeinflusst werden. Das erfindungsgemäße mikromechanische Bauteil vereint somit entscheidende Vorteile. So ist die Bruchanfälligkeit im selektiv verstärkten Bereich deutlich verbessert gegenüber den nicht-verstärkten Bereichen. Weiterhin ist es möglich, bei elastischen Bauteilen durch bestimmte Bereiche, die verstärkt werden, die elastische Verformung bzw. Biegefestigkeit selektiv einzustellen. In einem mechanischen Uhrwerk liegen eine Vielzahl von mechanischen Belastungsfällen vor. So werden Hemmbauteile (Anker und Ankerrad) beispielsweise auf Schlag und auch dynamisch auf Druck beansprucht. Insbesondere durch die Schlagbeanspruchung kann es zur Delamination der Diamantschicht kommen. Die schlagbeanspruchten Bereiche sind gut lokalisierbar. Eine gezielte Erhöhung der Schichtdicke der Diamantschicht in diesen Bereichen ist deshalb vorteilhaft. Darüber hinaus kann die lokale Verstärkung auch vorteilhaft für die Montage derartiger Bauteile genutzt werden. Z.B. kann die Diamantschichtdicke eines Achslochs zur Aufnahme einer Achse lokal verstärkt werden, so dass das Bauteil auf die Stahlachse aufgepresst werden kann. Damit entfallen aufwändige Klebeschritte. Letztlich hat die spezifische Verstärkung der Diamantschicht bzw. der DLC-Schicht auch einen Einfluss auf die Verschleißeigenschaften, so dass auch hierdurch noch Verbesserungen erreicht werden können, z.B. durch selektive Erhöhung des Verschleißvolumens an mechanisch besonders beanspruchten Bereichen.

Beim erfindungsgemäßen Bauteil werden deshalb der Ort und die Art der Verstärkung spezifisch nach seinem Einsatzzweck ausgewählt/eingestellt. So wird der verstärkte Bereich bei Bauteilen die mit einem anderen Bauteil in Kontakt stehen, mindestens an dieser Seitenfläche, die mit dem anderen Bauteil in Berührung kommt, den verstärkten Bereich aufweisen. Bei elastischen Bauteilen hingegen wird der verstärkte Bereich so ausgewählt sein, dass die Verformung in der gewünschten Art und Weise gesteuert wird. Der verstärkte Bereich kann dabei für sich gesehen eine einheitliche Schichtdicke aufweisen oder aber der verstärkte Bereich besitzt eine variierende Schichtdicke. Unter einer variierenden Schichtdicke wird verstanden, dass sich der verstärkte Bereich von einer Ausgangsschichtdicke kontinuierlich oder auch in Form einer bestimmten vorgegebenen Kurve zu einem niedrigeren Wert erniedrigt. Auch ist selbstverständlich von der Erfindung eine gestufte Ausbildung der Schichtdicke möglich.

Die Schichtdicke der Beschichtung auf der Ober- bzw. Unterseite des mikromechanischen Bauteils liegt bevorzugt im Bereich von 0,5 bis 50 µm, besonders bevorzugt im Bereich von 2 µm bis 7 µm. Die Schichtdicke der Beschichtung der Seitenfläche kann nun um bis zu 100% kleiner sein als auf der Ober- bzw. Unterseite des mikromechanischen Bauteils. Die Schichtdicke der Seitenfläche kann damit gezielt lokal moduliert werden. Wenn die Schichtdicke der mindestens einen Seitenfläche auf die Ober- und/oder Unterseite normiert wird, so kann die normierte Schichtdicke der Seitenflächen, bezogen auf den Minimalwert, um mehr als 10 %, bevorzugt um mehr als 20 %, besonders bevorzugt um mehr als 100 % variieren. Die Auswahl der Schichtdicke im nicht-verstärkten Bereich als auch im verstärkten Bereich der Seitenfläche richtet sich nach dem Anwendungsfall.

Das mikromechanische Bauteil wie vorstehend beschrieben ist ein Bauteil, das aus einem mindestens zwei Seitenflächen sowie einer Ober und Unterseite aufweisenden Trägermaterial gebildet ist, wobei die Diamantschicht bzw. die DLC-Schicht alle Seiten und Flächen vollflächig im Sinne einer 3D-Beschichtung umgibt. Die Erfindung umfasst auch Bauteile, bei denen die mindestens zwei Seitenflächen zusammen fallen, so dass eine umlaufende Seitenfläche entsteht. Bevorzugt ist das mikromechanische Bauteil im Querschnitt ein Bauteil, das einen viereckigen, bevorzugt einen rechteckigen Querschnitt aufweist. In diesem Fall hat das Bauteil mindestens zwei Seitenflächen. Beispiele für derartige mikromechanische Bauteile, die einen rechteckigen Querschnitt aufweist, sind insbesondere Bauteile im Uhrwerksbau, wie z.B. Uhrwerksbauteile ausgewählt aus der Gruppe bestehend aus Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern, Unruhen. Ganz besonders bevorzugt ist das mikromechanische Bauteil eine Zugfeder.

In Bezug auf das Trägermaterial unterliegt das mikromechanische Bauteil keinerlei Beschränkungen. Das Trägermaterial ist bevorzugt ausgewählt aus der Gruppe bestehend aus:
a) Halbmetallen, bevorzugt Kohlenstoff, Silizium oder Germanium;
b) metallischen Materialien, bevorzugt Fe, Ni, Cr, Co, Cu, Mn, V, Ti, Sc, W, Ta, Mo, Nb, Pt, Au, Rh;
c) Legierungen aus den unter b) genannten metallischen Materialien; oder
d) metallischen Karbiden der refraktären Metalle Ti, Ta, W, Mo, Ni; oder
e) eisenhaltigen Werkstoffen, wie Stahl; oder
f) Verbundwerkstoffen aus keramischen Werkstoffen in einer metallischen Matrix (Cermets), Hartmetallen, gesinterten Carbidhartmetallen, wie z.B. Cobalt oder Nickel-gebundenen Wolframkarbiden oder Titankarbiden; oder
g) kohlenstoff- und/oder stickstoff- und/oder bor- und oder sauerstoffhaltigen keramischen Werkstoffen, wie z.B. Siliziumkarbid, Siliziumnitrid, Bornitrid, Titannitriden, AlN, CrN, TiAlN, TiCN, und/oder TiB₂, Glaskeramiken, Saphir;
h) Kohlenstoff, wie z.B. Graphit, einkristalliner Diamant, polykristalliner Diamant, nanokristalliner Diamant.

Die Erfindung umfasst ferner Ausführungsformen, bei denen auf der Beschichtung, insbesondere im Bereich der Verstärkung, noch eine zusätzliche Abschlussschicht aus sp²-angereichertem Kohlenstoff aufgebracht ist. Es kann sich dabei auch um eine Gradientenschicht handeln, d.h. eine Schicht, die sich ausgehend von der Diamantschicht von einer sp³-haltigen Schicht zu einer sp²-haltigen Schicht ändert. Durch das Aufbringen einer sp²-haltigen Schicht kann ebenfalls eine elektrische Leitfähigkeit realisiert werden, welche elektrostatischen Aufladungseffekten entgegenwirkt.

Die Erfindung umfasst weiterhin auch ein Verfahren zur Herstellung eines mikromechanischen Bauteils wie im Folgenden beschrieben.

Erfindungsgemäß wird von einem Trägermaterial ausgegangen, das in Substratform vorliegt. Im Falle von Silizium als Trägermaterial kann hier bevorzugt ein Siliziumwafer (oder SOI, Silicon on Insulator) als Substratplatte eingesetzt werden. Hierbei bilden die Wafer-Oberseite und Wafer-Unterseite später die Ober- bzw. Unterseite des mikromechanischen Bauteils. Die Seitenflächen werden in den folgenden Schritten hergestellt: In einem nächsten Schritt erfolgt nun eine Strukturierung des Trägermaterials, wobei hier durch einen im Wesentlichen zur Oberfläche der Substratplatte senkrechten Ätzschritt die Form des mikromechanischen Bauteils ausgebildet wird. Dieser Schritt kann z.B. mit Hilfe des DRIE (Deep Reactive Ion Etching) Verfahrens erfolgen. Wobei zunächst mittels Photolithografie Bereiche definiert werden, die vor dem Ätzangriff geschützt werden sollen.

Im Falle eines SOI-Substrates wird nach der oben beschriebenen Durchführung des DRIE-Schrittes des Device layers des SOI-Wafers das Substrat vom Device layer getrennt. Dies geschieht durch einen chemischen Ätzangriff des Oxids.

Nach der Reinigung des Wafers erfolgt dann eine Nukleation des Trägermaterials mit kohlenstoffhaltigen Edukten zur Bildung von Diamantkeimen und im Anschluss daran erfolgt ein Aufwachsen der Diamantschicht mittels einer Gasphasenabscheidung, z.B. durch Hot Filament- oder Plasma-gestützte Verfahren.

Erfindungswesentlich beim Verfahren ist somit, dass die sich durch den Siliziumätzschritt ergebende Spaltbreite zwischen freigelegtem Bauteil und (Rest-) Wafer entsprechend variiert wird. Die Qualität und Geschwindigkeit des Siliziumätzangriffs wird sehr stark von der Spaltbreite beeinflusst. Aus diesem Grund wird bislang, dem Stand der Technik folgend, eine konstante Grabenbreite mit meist geringer Ausdehnung verwendet. Eine größere Grabenbreite kann aber durch die Einbringung von Opferstrukturen konstruktiv erreicht werden, ohne die für den Siliziumätzschritt optimale Grabenbreite ändern zu müssen. Die Erfinder konnten nämlich zeigen, dass eine bestimmte Relation zwischen der Spaltbreite und der Dicke der Beschichtung, bei Bildung der Diamantschicht, besteht. Wenn nämlich die Spaltbreite vergrößert wird, so wird auch die Beschichtungsdicke der beim Aufwachsen gebildeten Diamantschicht bzw. DLC-Schicht erhöht. Obwohl der gesamte Wafer mit den darin enthaltenen Bauteilen in einem Prozessschritt mit Diamant beschichtet wird und keine besonderen Vorkehrungen zur Maskierung bestimmter Bereiche getroffen werden, gelingt es allein durch spezifisches Strukturieren und gezielte Auswahl der Spaltbreite, die Schichtdicke auf dem Trägermaterial variabel einzustellen. Die Spaltbreite bzw. die Größe der angebotenen Substratoberfläche pro Oberflächeneinheit (bezogen auf die perforierte Waferoberfläche) beeinflusst nämlich die Durchdringung der Spalten mit reaktiven Spezies während des Beschichtungsprozesses und führt dadurch zu einer lokalen Erhöhung bzw. Verringerung der Wachstumsrate. Sehr geringe Spaltbreiten führen zu einem vollständigen Wachstumsstopp auf der Seitenfläche und resultieren in einem nicht-beschichteten Bereich der Seitenfläche. Erstaunlicherweise konnte ebenfalls gezeigt werden, dass nanokristalline Diamantschichten auch bei geringen Spaltbreiten sehr homogen abgeschieden werden können. Insbesondere bei hohen Aspektverhältnissen bildet sich jedoch auch auf der Seitenflanke bzw. Seitenfläche ein Schichtdickengradient, welcher zu einem konkaven Schichtdickenprofil auf der Seitenflanke führen kann. Dieser Effekt kann ebenfalls vorteilhaft genutzt werden, um z.B. die Deformation einer Spiralfeder (z.B. Zugfeder oder Unruhfeder eines Uhrwerkes) in einer Ebene zu halten und damit eine unkontrollierte Deformation der Federwindungen in Achsrichtung zu vermeiden.

In Bezug auf das Beschichtungsverfahren unterliegt die Erfindung selbstverständlich keinerlei Beschränkungen, so dass beim erfindungsgemäßen Verfahren eine an und für sich bekannte chemische Gasphasenabscheidung (CVD), bevorzugt eine Hot Filamentabscheidung; erfolgen kann.

Die Erfindung wird nachfolgend anhand der Figuren 1 bis 10 näher erläutert.
Figur 1a) zeigt im Querschnitt ein rechteckiges Bauteil des Standes der Technik mit Beschichtung und Figur 1b) ebenfalls ein rechteckiges Bauteils, jedoch mit einer erfindungsgemäßen Beschichtung. In Figur 1c) sind schematisch verschiedene Spaltbreiten zur Erzeugung von unterschiedlichen Schichtdicken eines rechteckigen Bauteils dargestellt und in Figur 1d) ist graphisch dargestellt, wie sich die normierte Beschichtungsdicke mit der Geometrie der Spaltbreite verändert.
Figur 2 zeigt ein Substrat mit zwei erfindungsgemäßen Bauteilen, und zwar einem Bauteil a und einem Bauteil b mit variierenden Spaltbreiten.
Figur 3 zeigt die Auswertung für Bauteil a in Form von zwei graphischen Darstellungen in Bezug auf die absolute Schichtdicke und die normierte Schichtdicke.
In Figur 4 sind dieselben Auswertungen dargestellt, jedoch hier bezüglich Bauteil b aus Figur 2.
Figur 5 zeigt in der Draufsicht einen Wafer mit strukturiertem rechteckigem Bauteil und verschiedenen Spaltbreiten, wie es bereits schematisch in Figur 1c) dargestellt ist.
Figur 6 zeigt eine zusätzliche Ausführungsform, bei der sich die Spaltbreite kontinuierlich ändert.
Figur 7 zeigt einen Anker, der aus einem Wafer strukturiert ist und eine einheitliche Beschichtungsdicke aufweist, wohingegen
Figur 8 ein erfindungsgemäßes gleiches Bauteil mit einer variierenden Spaltbreite zeigt.
Figur 9 zeigt in einem Wafer eine strukturierte Feder mit unterschiedlichen Spaltbreiten.
Figur 10 zeigt den Zusammenhang zwischen Oberflächenrauheit und Schichtdicke.

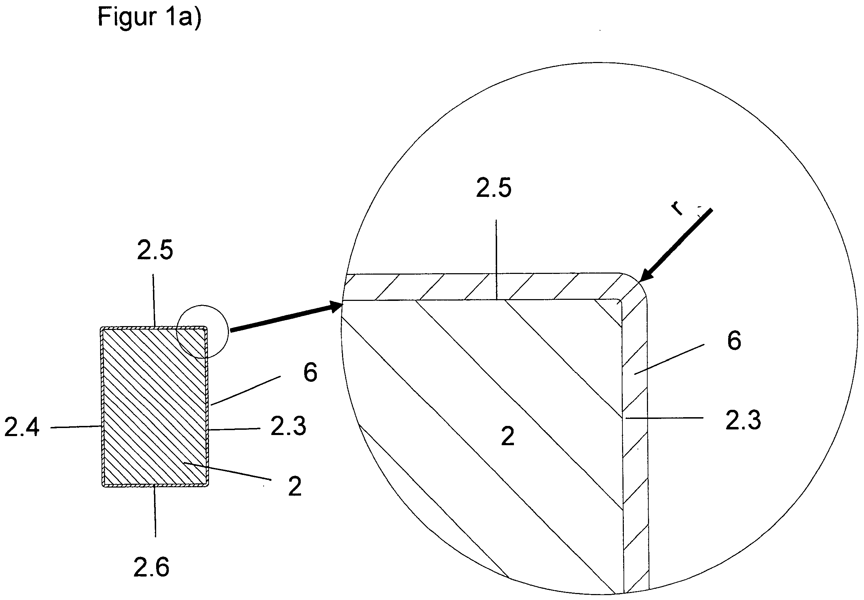

In Figur 1a) im linken Teil ist schematisch ein rechteckiges Bauteil 2 im Querschnitt gezeigt, das ganzflächig, d.h. von allen Seiten, sowohl von den Seitenflächen 2.3 und 2.4, als auch von der Oberseite 2.5 und der Unterseite 2.6 von einer Beschichtung 6 umgeben ist. Bei der schematischen Darstellung in Figur 1a) handelt es sich um ein Bauteil des Standes der Technik, d.h. um ein Bauteil, bei dem in Form einer 3D-Beschichtung eine Schicht 6 um die Seitenflächen 2.3 und 2.4, um die Oberseite 2.5 und um die Unterseite 2.6 vorgesehen ist. Da im Stand der Technik bisher kleine konstanten Spaltbreiten verwendet wurden, ist die Beschichtungsdicke auf der Seite 2.3 etwas kleiner als auf der Oberseite 2.5. Im rechten Teil der Figur 1a) ist in vergrößerter Darstellung die Ausbildung der Ecke dargestellt. Wie aus der Figur 1a), rechter Teil, hervorgeht, ist durch die Beschichtung 6 des Bauteils 2 im Kantenbereich, d.h. beim Aufeinandertreffen der Seitenfläche 2.3 mit der Oberseite 2.5 eine Rundung entstanden. Im rechten Teil ist dies mit dem Pfeil und r, d.h. für den Radius dieser Rundung dargestellt.

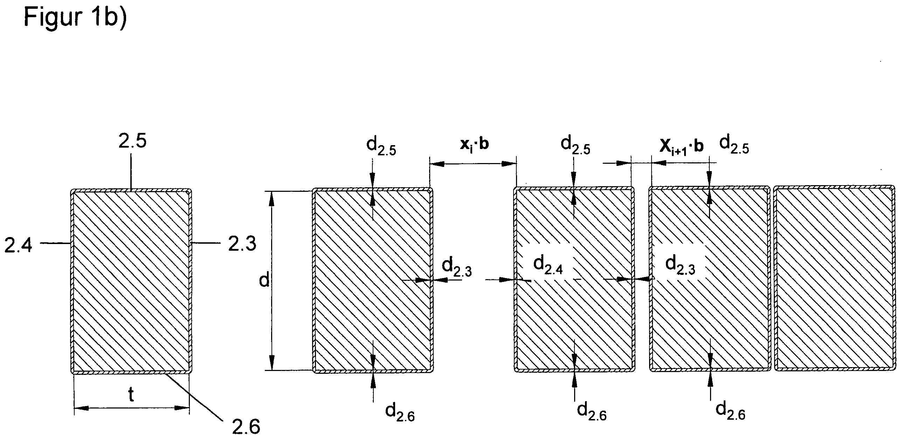

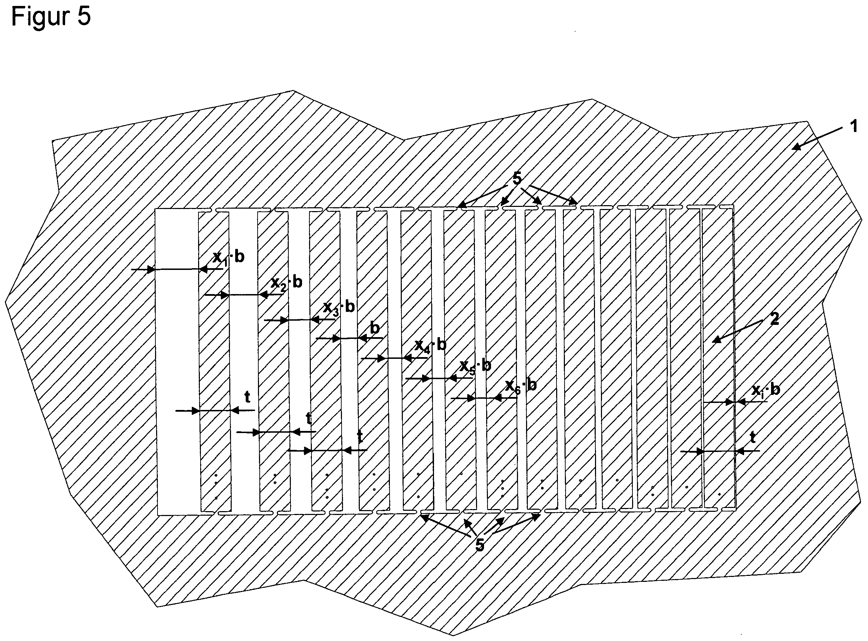

Figur 1b) zeigt nun schematisch, wie durch Variation der Spaltbreite unterschiedliche Schichtdicken, z.B. auf der Seitenfläche 2.3 und 2.4 realisiert werden können. Mit x₁b ist dabei die erste Spaltbreite bezeichnet und mit t die Breite des Bauteils. Mit x₂, x₃ und x₄ sind dann die weiteren Spaltbreiten bestimmt. Hierzu wird auch auf Figur 5 verwiesen, die eine ähnliche Anordnung zeigt, bei der die einzelnen Bauteile 2 in einem Substrat 1 strukturiert sind.

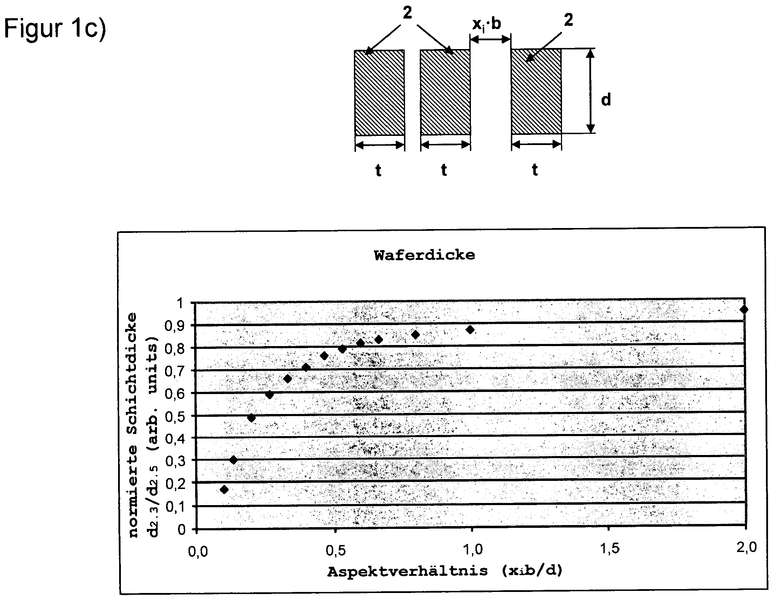

Mit einer wie in Figur 1b) dargestellten Struktur wurde der generelle Zusammenhang zwischen der Schichtdicke und der Spaltbreite ermittelt. Dies ist in Figur 1c) dargestellt.

In Figur 1c) ist auf der Horizontalachse das Aspektverhältnis dargestellt, d.h. das Verhältnis von Spaltbreite b zur Waferdicke d. Die Hochachse bezeichnet die normierte Beschichtungsdicke. Unter der normierten Beschichtungsdicke wird erfindungsgemäß diejenige Schichtdicke verstanden, die auf die Oberseiten- und/oder Unterseitenschichtdicke bezogen ist. Die einzelnen Messwerte ergeben sich somit dadurch, dass die Beschichtungsdicke der Oberseite, z.B. 2.5, durch die Beschichtungsdicke einer Seitenfläche, z.B. der Seitenfläche 2.3, geteilt wird. Im Idealfall ergibt sich dann demnach, wenn die Beschichtungsdicke auf der Seitenfläche, z.B. 2.3, die gleiche Dicke aufweist wie auf der Oberseite bzw. auf der Unterseite, eine normierte Beschichtungsdicke von 1.

Figur 1c) zeigt nun für eine Strukturierung, wie sie in Figur 1b) dargestellt ist, dass das Aspektverhältnis von der normierten Beschichtungsdicke abhängig ist. Durch diesen Zusammenhang können nun die Dickenverhältnisse auf den Seitenflächen 2.3 und/oder 2.4 ganz gezielt eingestellt werden.

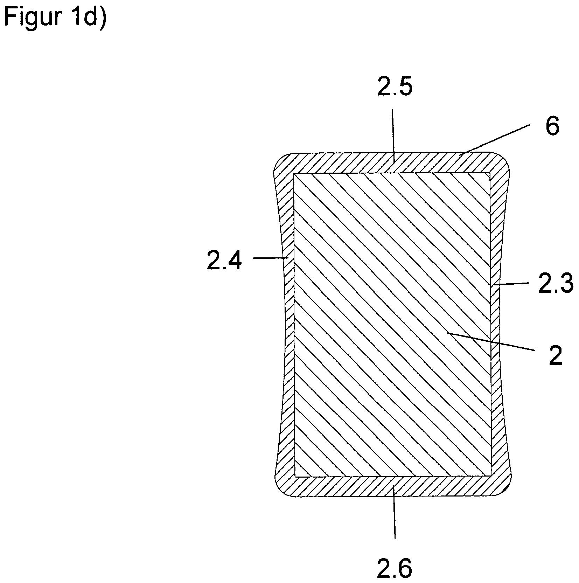

In Figur 1d) ist nun ebenfalls im Querschnitt ein erfindungsgemäßes Bauteil 2 dargestellt, das wiederum einen rechteckigen Querschnitt besitzt und die Seitenflächen 2.3, 2.4, eine Oberseite 2.5 und eine Unterseite 2.6 aufweist. Von den Erfindern wurde festgestellt, dass eine derartige Beschichtung mit einer leicht konkaven Seitenflächenbeschichtung 2.3 und 2.4 auch dann erreicht wird, wenn mit einem Spalt mit konstanter Spaltbreite gearbeitet wird, jedoch hier mit der Maßgabe, dass sehr kleine Spaltbreiten eingesetzt werden. Beschichtungen, wie sie in Figur 1d) gezeigt sind, werden erhalten, wenn mindestens ein Verhältnis von 1:5 für Spaltbreite b zu Waferdicke d eingehalten wird.

Die Erfinder konnten weiterhin dann zeigen, wenn ein sehr großer Spalt, nämlich ein Spalt realisiert wird, der mindestens 2d entspricht, eine Sättigung bei der Beschichtung vorliegt, d.h. wenn derartige Spaltbreiten realisiert werden, die über 2d hinaus gehen, wird kein nennenswerter Dickenzuwachs mehr erreicht.

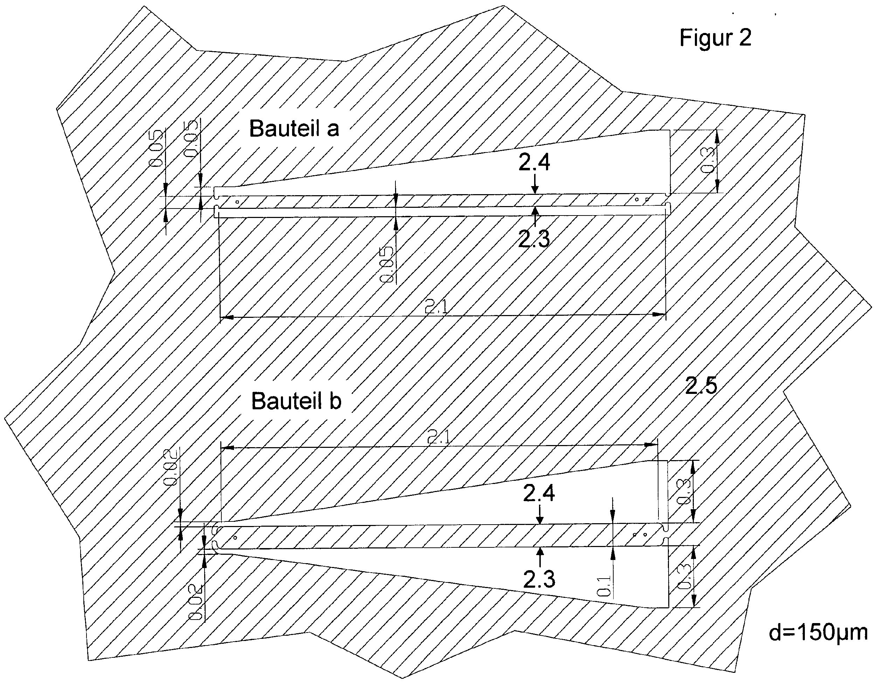

Figur 2 zeigt nun ein weiteres Beispiel dafür, wie die erfindungsgemäßen Bauteile durch Strukturierung gezielt beeinflusst werden können.

In Figur 2 ist ein Siliziumwafer dargestellt, dessen Oberseite mit 2.5 bezeichnet ist. Wie aus der Figur 2 hervorgeht, sind in dem Siliziumwafer zwei Bauteile, und zwar ein Bauteil a und ein Bauteil b, strukturiert worden. Die Dicke d des Wafers beträgt 150 µm. Im konkreten Beispiel nach Figur 2 beträgt sowohl für das Bauteil a als auch für das Bauteil b die Balkenlänge 2,1 mm. Das Bauteil a ist dabei so strukturiert worden, dass auf der Seitenfläche 2.3 ein gleichbleibender Spalt mit einer Spaltbreite von 0,05 mm realisiert worden ist, wobei sich auf der gegenüber liegenden Seite 2.4 ein sich aufweitender Spalt ausgehend von einer Spaltbreite wiederum von 0,05 mm bis zu 0,3 mm erstreckt.

Das Bauteil b hingegen ist symmetrisch strukturiert worden, d.h. es finden sich, analog wie bei Bauteil a für die Seitenfläche 2.4 schon beschrieben, zwei sich aufweitende Spalten auf beiden Seiten. Beim Bauteil b weitet sich der Spalt von 0,02 mm wiederum bis zu 0,3 mm auf und auf der Seitenfläche 2.3 in analoger Weise. Die Dicke t des Bauteils beträgt 0,1 mm.

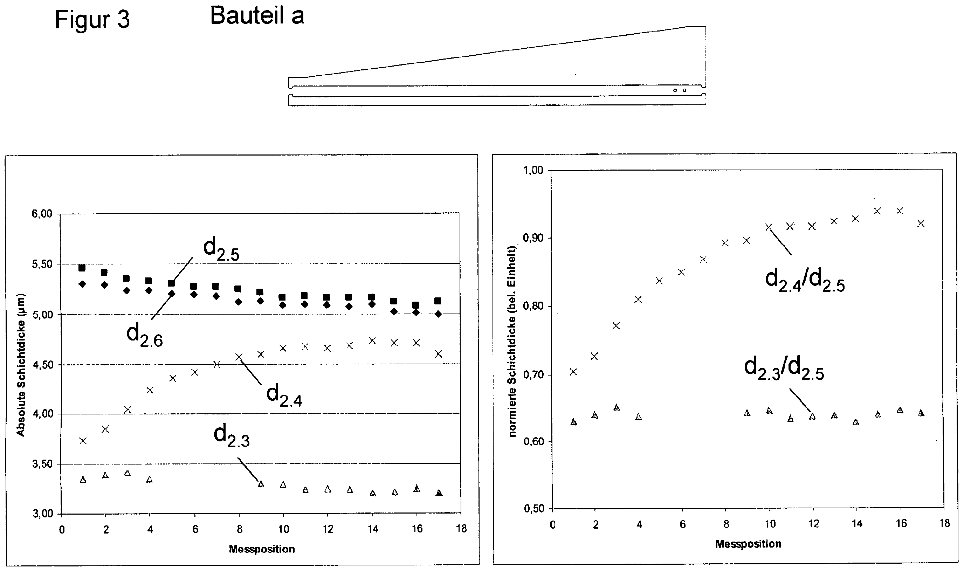

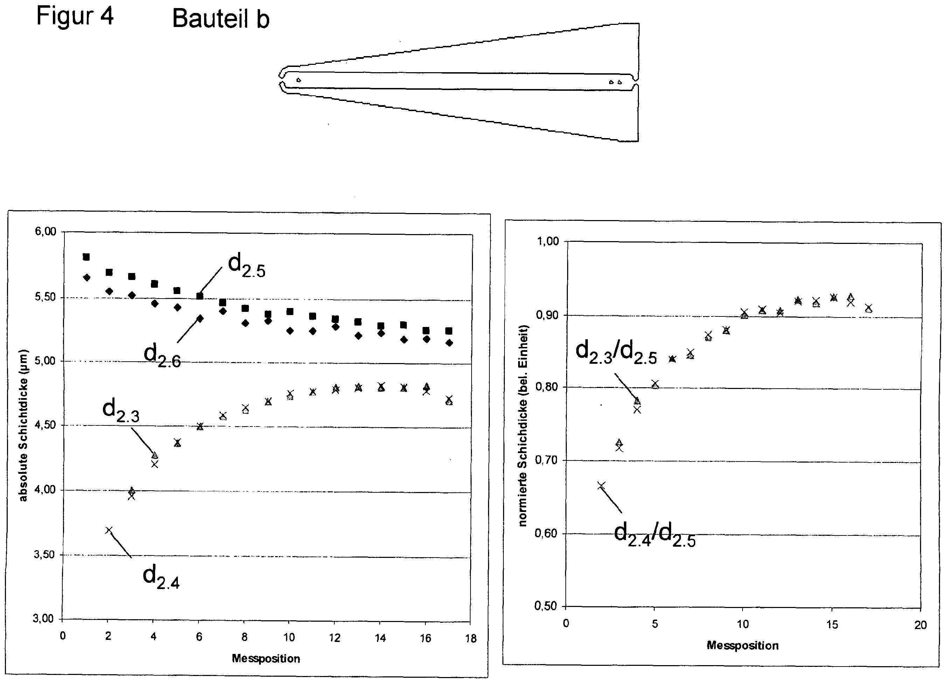

In Figur 3 sind nun die Zusammenhänge zwischen den absoluten Schichtdicken und den normierten Schichtdicken für Bauteil a und in Figur 4 dieselben Messergebnisse für das Bauteil b dargestellt.

In Figur 3 ist das Bauteil a noch einmal, wie es auch schon aus der Figur 2 hervorgeht, schematisch dargestellt.

Die linke Graphik enthält nun die Messergebnisse, die auf der Hochachse die absoluten Schichtdicken in µm zeigen und auf der Horizontalachse die Anzahl der Messpositionen. Bei einer Balkenlänge von 2,1 mm wurden von links nach rechts 19 äquidistante Längenabschnitte definiert, die als Messpunkte herangezogen wurden. Jeweils der erste und letzte Messpunkt am Balkenbeginn und Balkenende wurden aus messtechnischen Gründen nicht erfasst. D.h., der erste Messwert erfolgte nach 110 µm, letzter Messwert 110 µm vor Ende des Balkens.

In der linken Graphik sind nun für die einzelnen Messpositionen wie vorstehend beschrieben die absoluten Schichtdicken dargestellt. Wie aus der Graphik hervorgeht, ergibt sich somit für das Bauteil a eine absolute Schichtdicke der Beschichtung auf der Seitenfläche 2.3, d.h. auf derjenigen Seitenfläche, bei der ein gleichbleibender Spalt vorhanden war, von etwa 3,4 µm. Die Schichtdicken auf den jeweiligen Ober- und Unterseiten, die in der Graphik ebenfalls dargestellt und gesondert bezeichnet worden sind, sind nahezu konstant und bewegen sich im Bereich zwischen 5,0 µm und 5,5 µm. Wie nun aus dem linken Teil der Figur 3 hervorgeht, resultiert auf der Seitenfläche 2.4 des Bauteils a ein sich allmählich vergrößernde Schichtdicke. Derselbe Zusammenhang wurde bereits in Figur 1d) näher beschrieben.

In der rechten Graphik sind nun wiederum auf der Horizontalachse die einzelnen Messpunkte dargestellt und auf der Hochachse ist die normierte Schichtdicke aufgetragen. Daraus ergibt sich für die normierte Schichtdicke für diejenige Seitenfläche 2.3, bei der ein gleichmäßiger Spalt gewählt worden ist, nahezu eine Gerade, wohingegen sich für die Seitenfläche 2.4 eine normierte Schichtdicke (d_{2.4}/d_{2.5}) ergibt, die sich in der angegebenen Weise verändert.

Durch die nun gefundenen Zusammenhänge zwischen der Spaltbreite und der Beschichtungsdicke lassen sich erfindungsgemäß Bauteile konstruieren, die an ganz definierten Stellen entsprechende Schichtdickenveränderungen aufweisen, so dass damit die Eigenschaften der Bauteile gezielt beeinflusst werden können.

In Figur 4 sind nun dieselben Messergebnisse dargestellt, und zwar hier für das Bauteil b. Wie daraus hervorgeht, ergibt sich eine normierte Schichtdicke für das symmetrisch strukturierte Bauteil, das sich kontinuierlich von 0,65 auf 0,92 mm vergrößert.

In Figur 5 ist beispielhaft in Form eines Siliziumwafers 1, der als Substrat dient, dargestellt, wie entsprechende Spaltbreiten durch Strukturierung hergestellt werden können. Mit x₁b ist damit die erste Spaltbreite für das erste mikromechanische Bauteil dargestellt und mit t wiederum, wie schon aus Figur 1c) hervorgeht, die Breite des Bauteils. Mit x₂, x₃ und x₄ sind dann die weiteren Spaltbreiten bestimmt. Die einzelnen mikromechanischen Bauteile werden dabei über Stege 5 im Substrat 1 gehalten. Mit Hilfe einer solchen Struktur wurde der generelle Zusammenhang zwischen Schichtdicke und Spaltbreite (Figur 1d)) ermittelt.

Figur 5 verdeutlicht nachhaltig, dass auf sehr einfache Weise durch den wie in Figur 1d) gezeigt gefundenen Zusammenhang zwischen dem Aspektverhältnis und der Beschichtungsdicke ganz gezielt unterschiedliche Beschichtungsdicken auf den Seitenflächen der erfindungsgemäßen Bauteile realisiert werden können. Damit steht erstmalig eine gezielte Beeinflussung der Schichtdicken und damit von verstärkten Bereichen auf den Seitenflächen von mikromechanischen Bauteilen zur Verfügung. An dieser Stelle ist auch hervorzuheben, dass dadurch, dass diese Verstärkung nur gezielt auf einzelnen Bereichen der Seitenflächen aufgebracht werden kann, auch ein deutlicher Kostenvorteil einhergeht. Das erfindungsgemäße mikromechanische Bauteil zeichnet sich somit nicht nur dadurch aus, dass durch die gezielten verstärkten Bereiche aus Diamant bzw. DLC verbesserte Gebrauchseigenschaften resultieren, sondern dass gleichzeitig durch geringen Materialverbrauch und dünne Ausbildung der Diamantschichten auf den nicht im funktionalen Bereich angeordneten Stellen große Kostenvorteile erreicht werden können.

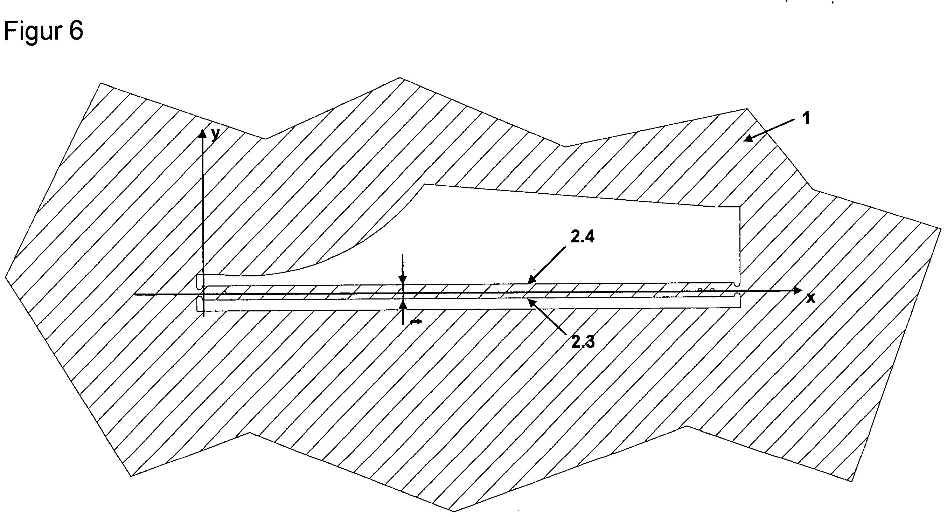

Figur 6 zeigt eine weitere Möglichkeit, bei der wiederum auf der einen Seitenfläche 2.3 eine gleichbleibende normierte Schichtdicke realisiert worden ist und auf der anderen Seitenfläche 2.4 eine im rechten Teil monoton abfallende Schichtdicke und im linken Teil eine sich in einer bestimmten vorgegebenen Kurve zur "Zielschichtdicke" vermindernde Schichtdicke durch Ausbildung eines entsprechenden Spaltes gewählt ist.

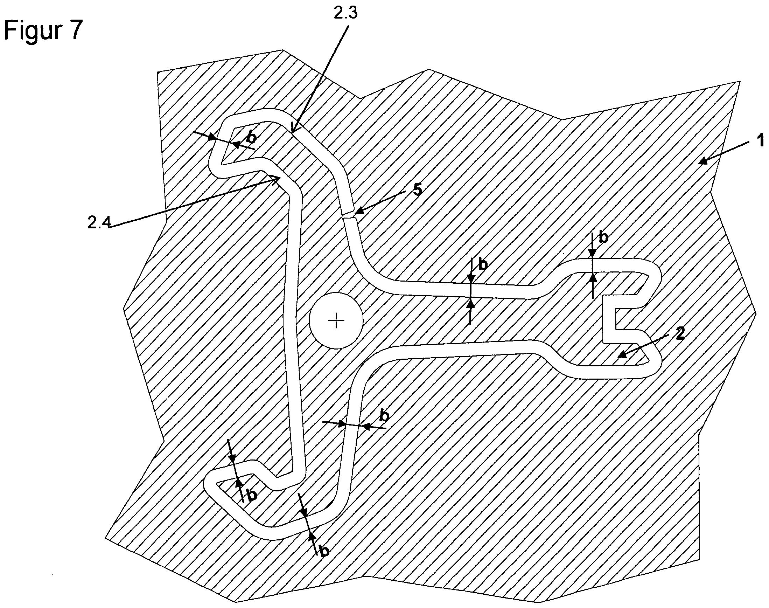

In Figur 7 ist nun ein Uhrwerksbauteil in Form eines Ankers dargestellt, wobei die Figur 5 ein Bauteil nach dem Stand der Technik zeigt, d.h. eine Strukturierung, bei der umlaufend um das Ankerbauteil 2 eine gleichbleibende Spaltbreite b realisiert worden ist, wie es konventionell üblich ist. Der Anker wird wieder über Stege 5 im Substratmaterial 1 gehalten. Mit 2.3 und 2.4 sind wieder die Seitenflächen beschrieben.

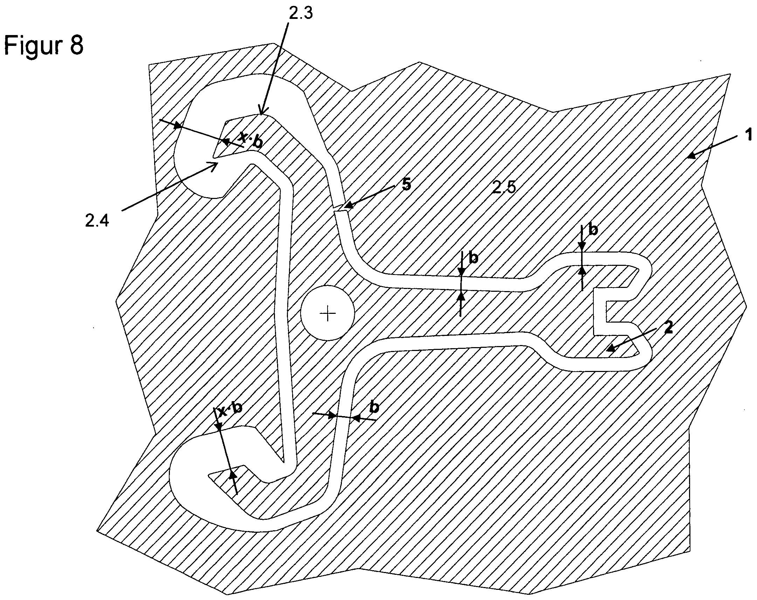

Im Gegensatz hierzu zeigt nun Figur 8 eine erfindungsgemäße Ausbildung eines derartigen Ankerbauteils, die sich dadurch auszeichnet, dass im hoch beanspruchten Bereich eine größere Spaltbreite b als es im Stand der Technik bisher der Fall ist, gewählt worden ist. Dadurch wird somit im hoch beanspruchten Bereich des Ankerbauteils eine mindestens doppelt so große Schichtdicke der Diamantschicht erreicht, wie es im Stand der Technik üblich ist. An dieser Stelle ist noch einmal hervorzuheben, dass dadurch, dass der verstärkte Bereich nur lokal, und zwar an den Stellen, angeordnet ist, die funktional in einem Zusammenhang mit einem weiteren Bauteil stehen, geringere Kosten anfallen, da die übrige Schichtdicke in einer dünnen Ausführung gewählt werden kann.

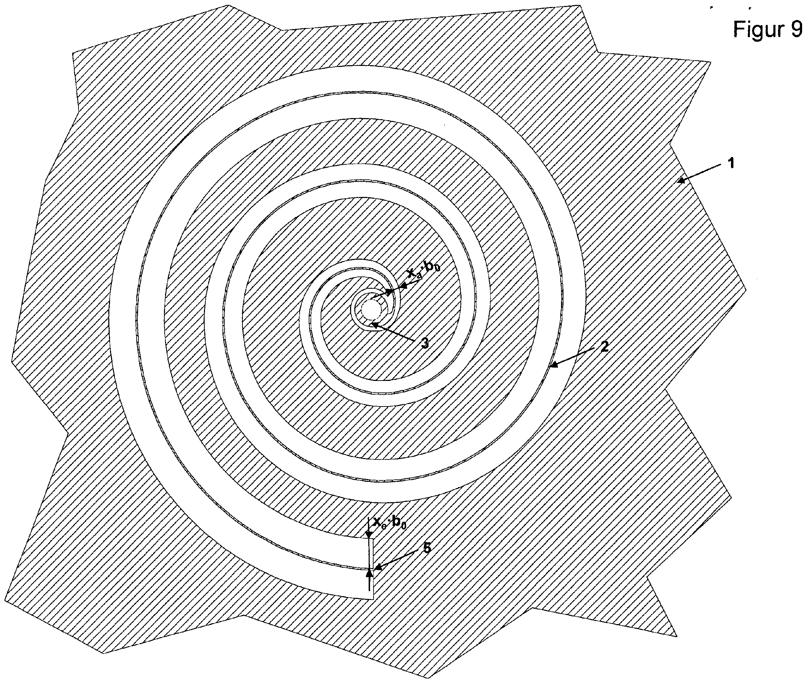

In Figur 9 ist ein weiteres Beispiel gezeigt, und zwar in Form einer Uhrfeder 2. Die Uhrfeder 2 wird wiederum über Stege 5 in einem Siliziumwafer, der als Substrat 1 fungiert, gehalten. Wie aus Figur 9 hervorgeht, ist die Spaltbreite b dabei so gewählt, dass sich diese Spaltbreite vom zentralen Mittelpunkt 3 aus zum Endpunkt der Feder 5 hin kontinuierlich verbreitert. Dadurch wird nun im Gegensatz zum Stand der Technik eine Feder erhalten, die durch die unterschiedliche Beschichtungsdicke, die sich kontinuierlich zum Endpunkt hin verbreitert, ein optimales Gangverhalten aufweist.

Selbstverständlich kann zusätzlich zur graduellen Ausgestaltung der Diamantschichtdicke auf den Seitenflächen zusätzlich auch noch die Federblattbreie des Siliziumsubstrats variiert werden.

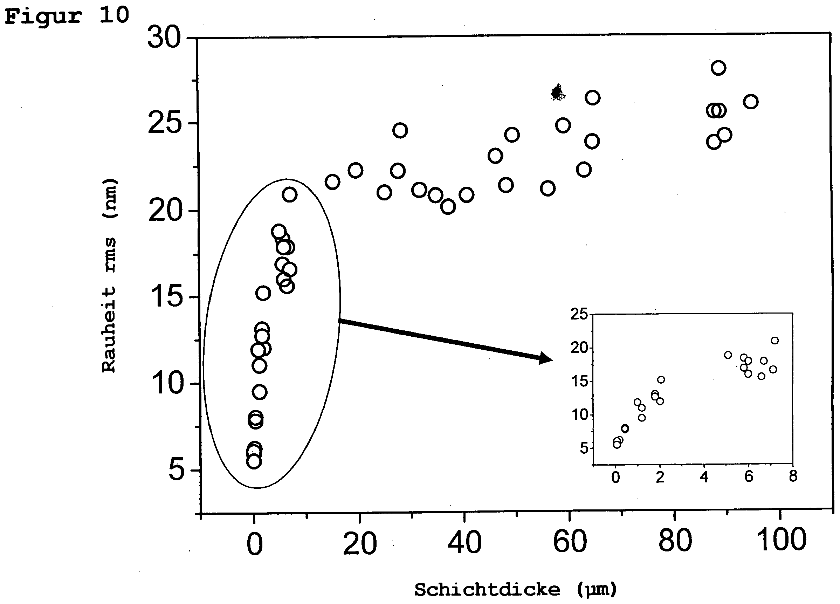

Figur 10 zeigt nun den Zusammenhang zwischen der Rauheit rms in nm mit der Schichtdicke in µm. Wie die Erfinder zeigen konnten, hängt die Schichtdicke mit der Rauheit rms zusammen. Dadurch eröffnen sich nun zusätzliche Möglichkeiten, die Beschichtung 6 weiter dadurch zu optimieren, dass aufgrund des Zusammenhangs, wie er in Figur 10 dargestellt ist, es möglich ist, auf einer Seitenfläche nicht nur die Beschichtung 6 so zu modulieren, dass ein verstärkter Bereich entsteht, sondern dass ein und dieselbe Oberfläche in Abhängigkeit der Dicke über unterschiedliche Rauheiten verfügt. Wie Figur 1 darlegt, zeigen Oberflächen mit einer sehr geringen Schichtdicke auch eine sehr feine Rauheit, wohingegen Oberflächenbereiche, die dann eine erhöhte Schichtdicke besitzen, auch einen größeren Grad an Rauheit in rms aufweisen. Dadurch besteht eine zusätzliche Einflussnahmemöglichkeit auf die Oberflächengestaltung der Seitenflächen, so dass dadurch das erfindungsgemäße Bauteil noch zusätzlich optimiert werden kann.

## Patentansprüche

1. Mikromechanisches Bauteil (2) mit
einer Ober- und Unterseite (2.5, 2.6) und
mindestens zwei Seitenflächen (2.3, 2.4) und
einer das Bauteil (2) vollflächig umgebenden Beschichtung (6) aus mikro- oder nanokristallinem Diamant und/oder diamantartigem Kohlenstoff (DLC),
**dadurch gekennzeichnet, dass** auf mindestens einer Seitenfläche (2.3, 2.4), über mindestens einen Teil dieser Seitenfläche (2.3, 2.4), die Beschichtung (6) gegenüber der Beschichtung (6) der Ober- und/oder Unterseite (2.5, 2.6) eine kleinere Schichtdicke besitzt, so dass, bezogen auf die mindestens eine Seitenfläche (2.3, 2.4), die Schichtdicke der Beschichtung (6) variiert, so dass lokal verstärkte Bereiche entstehen und dass die Schichtdicke der Beschichtung (6) im Bereich von 0,5 bis 50 µm liegt,
die auf die Ober- und/oder Unterseite (2.5, 2.6) normierte Schichtdicke der mindestens einen Seitenfläche (2.3, 2.4), bezogen auf den Minimalwert, um mehr als 10 %, bevorzugt um mehr als 20 %, besonders bevorzugt um mehr als 100 % variiert und
die schlagbeanspruchten, die mechanisch beanspruchten oder die mit einem anderen Bauteil in Berührung kommenden Bereiche die verstärkten Bereiche aufweisen.

2. Mikromechanisches Bauteil nach Anspruch 1, **dadurch gekennzeichnet, dass** der verstärkte Bereich mindestens auf demjenigen Teil der mindestens einen Seitenfläche (2.3, 2.4) ausgebildet ist, der mit einem anderen Bauteil oder einem Bereich eines Bauteils in Kontakt bringbar ist.

3. Mikromechanisches Bauteil nach Anspruch 1 oder 2, **dadurch gekennzeichnet, dass** die auf der mindestens einen Seitenfläche (2.3, 2.4) angeordnete Beschichtung (6) mit konstanter Schichtdicke, einer variierenden Schichtdicke oder einem Schichtdickenprofil mit konkaver Form ausgebildet ist.

4. Mikromechanisches Bauteil nach mindestens einem der Ansprüche 1 bis 3, **dadurch gekennzeichnet, dass** das mikromechanische Bauteil (2) im Querschnitt einen viereckigen, bevorzugt einen rechteckigen Querschnitt, aufweist und zwei Seitenflächen (2.3, 2.4) sowie eine Oberseite und eine Unterseite (2.5, 2.6) aufweist.

5. Mikromechanisches Bauteil nach mindestens einem der Ansprüche 1 bis 4, **dadurch gekennzeichnet, dass** es ein Uhrwerksbauteil, ausgewählt aus der Gruppe bestehend aus Zugfedern, Ankern, Ankerrädern, Hemmbauteilen, Plateaus, Zahnrädern, Trieben, Lagersteinen, Decksteinen, Lagerzapfen, Wellen, Achsen, Federn, Zugfedern, Unruhfedern und/oder Unruhen, ist.

6. Mikromechanisches Bauteil nach Anspruch 5 in Form einer Zugfeder für ein Uhrwerk-Federhaus mit einer vorgegebenen Länge (L), die sich von einem inneren Ende bis zu einem äußeren Ende der Zugfeder erstreckt und einen viereckigen Querschnitt aufweist, wobei die Beschichtung (6) der Innenseite oder Außenseite über zumindest einen Teil der Länge (L) der Zugfeder eine größere Schichtdicke aufweist.

7. Mikromechanisches Bauteil nach mindestens einem der Ansprüche 1 bis 6, **dadurch gekennzeichnet, dass** das Trägermaterial ausgewählt ist aus der Gruppe bestehend aus
a) Halbmetallen, bevorzugt Kohlenstoff, Silicium oder Germanium;
b) metallischen Materialien, bevorzugt Fe, Ni, Cr, Co, Cu, Mn, V, Ti, Sc, W, Ta, Mo, Nb, Pt, Au, Rh;
c) Legierungen aus den unter b) genannten metallischen Materialien;
oder
d) Hartmetallen, bevorzugt Metallcarbiden, insbesondere Wolframcarbid.

8. Verfahren zur Herstellung eines mikromechanischen Bauteils nach mindestens einem der Ansprüche 1 bis 7 mit folgenden Schritten:
a) Bereitstellen einer aus einem Trägermaterial bestehenden Substratplatte,
b) Strukturieren des Trägermaterials durch einen im Wesentlichen zur Oberfläche der Substratplatte senkrechten Ätzschritt, unter Bildung eines Spaltes, mit der Maßgabe, dass die Spaltbreite in dem Bereich, in dem die Verstärkung erfolgen soll, größer ist als in den anderen Bereichen,
c) Nukleation des Trägermaterials mit kohlenstoffhaltigen Edukten zur Bildung von Diamantkeimen, und
d) Aufwachsen des Diamants mittels einer Plasmabehandlung, wie z.B. CVD.

9. Verfahren nach Anspruch 8, **dadurch gekennzeichnet, dass** nach Schritt d) eine Oberflächenbehandlung mittels Plasma durchgeführt wird.

10. Verfahren nach Anspruch 8 oder 9, **dadurch gekennzeichnet, dass** als Ätzschritt ein lonenätzen eingesetzt wird.

11. Verfahren nach mindestens einem der Ansprüche 8 bis 10, **dadurch gekennzeichnet, dass** als Substratplatte ein Silizium-Wafer eingesetzt wird.

12. Verfahren nach mindestens einem der Ansprüche 8 bis 11, **dadurch gekennzeichnet, dass** das aus dem Trägermaterial strukturierte mikromechanische Bauteil mittels Stegen im Substrat gehalten wird.

## Claims

1. Micromechanical component (2) having
a top face and a bottom face (2.5, 2.6) and
at least two side faces (2.3, 2.4) and
a coating (6) made of microcrystalline or nanocrystalline diamond and/or diamond-like carbon (DLC), the coating encompassing all the surfaces of the component (2),
**characterised in that** on at least one side face (2.3, 2.4), over at least a part of this side face (2.3, 2.4), the coating (6) has a smaller coating thickness than the coating (6) of the top face and/or the bottom face (2.5, 2.6), so that, in relation to the at least one side face (2.3, 2.4), the layer thickness of the coating (6) varies, so that locally reinforced areas result and that the layer thickness of the coating (6) lies in the range of 0.5 to 50 µm,
the coating thickness of the at least one side face (2.3, 2.4), normalized on the top face and or the bottom face (2.5, 2.6), varies, in relation to the minimum value, by more than 10%, preferably by more than 20%, particularly preferably by more than 100% and
the impact-stressed areas, the mechanically-stressed areas or the areas coming into contact with another component have the reinforced areas.

2. Micromechanical component according to claim 1,
**characterised in that** the reinforced area is formed at least on that part of the at least one side face (2.3, 2.4) which can be brought into contact with another component or with an area of a component.

3. Micromechanical component according to claim 1 or 2,
**characterised in that** the coating (6) arranged on the at least one side face (2.3, 2.4) is formed with a constant coating thickness, a varying coating thickness or a coating thickness profile having a concave shape.

4. Micromechanical component according to at least one of claims 1 to 3, **characterised in that** the micromechanical component (2) in cross-section has a quadrangular, preferably a rectangular, cross-section, and two side faces (2.3, 2.4) as well as one top face and one bottom face (2.5, 2.6).

5. Micromechanical component according to at least one of claims 1 to 4, **characterised in that** it is a clock mechanism component, selected from the group consisting of tension springs, escapements, escapement wheels, restricting components, plateaus, gears, pinions, bearing pads, cover pads, journal pins, shafts, axles, springs, tension springs, balance springs and/or balance wheels.

6. Micromechanical component according to claim 5 in the form of a tension spring for a barrel of a clock mechanism having a predefined length (L), which extends from an inner end up to an outer end of the tension spring and has a quadrangular cross-section, wherein the coating (6) on the inner side or outer side has a greater coating thickness over at least a part of the length (L) of the tension spring.

7. Micromechanical component according to at least one of claims 1 to 6, **characterised in that** the substrate is selected from the group consisting of:
a) semimetals, preferably carbon, silicon or germanium;
b) metallic materials, preferably Fe, Ni, Cr, Co, Cu, Mn, V, Ti, Sc, W, Ta, Mo, Nb, Pt, Au, Rh;
c) alloys of the metallic materials listed under b); or
d) hard metals, preferably metal carbides, particularly tungsten carbide.

8. Method for producing a micromechanical component according to at least one of claims 1 to 7 comprising the following steps:
a) preparing a substrate plate consisting of a substrate,
b) structuring the substrate by an etching step substantially perpendicular to the surface of the substrate plate, thereby forming a gap, with the proviso that the gap width in the area to be reinforced is greater than in the other areas,
c) nucleating the substrate with carbon-containing starting materials to form diamond seeds, and
d) growing the diamond by means of a plasma treatment, such as e.g. CVD.

9. Method according to claim 8, **characterised in that** following step d) a surface treatment by means of plasma is carried out.

10. Method according to claim 8 or 9, **characterised in that** an ion etching is used as the etching step.

11. Method according to according to at least one of claims 8 to 10, **characterised in that** a silicon wafer is used as the substrate plate.

12. Method according to according to at least one of claims 8 to 11, **characterised in that** the micromechanical component structured from the substrate is held in the substrate by means of lands.

## Revendications

1. Composant micro-mécanique (2) avec
un côté supérieur et un côté inférieur (2.5, 2.6) et
au moins deux surfaces latérales (2.3, 2.4) et
un revêtement (6) entourant sur toute sa surface le composant (2), constitué d'un diamant micro ou nano-cristallin et/ou de carbone de type diamant (DLC),
**caractérisé en ce que**, sur au moins une surface latérale (2.3, 2.4), au-dessus d'au moins une partie de cette surface latérale (2.3, 2.4), le revêtement (6) présente, par rapport au revêtement (6) du côté supérieure et/ou du côté inférieur (2.5, 2.6), une épaisseur de couche inférieure, de façon à ce que, par rapport à l'au moins une surface latérale (2.3, 2.4), l'épaisseur de couche du revêtement (6) varie de façon à ce que des zones renforcées localement apparaissent et à ce que l'épaisseur de couche du revêtement (6) soit de 0,5 à 50 µm,
l'épaisseur de couche, normalisée sur le côté supérieur et/ou inférieur (2.5, 2.6), de l'au moins une surface latérale (2.3, 2.4), varie, par rapport à la valeur minimale, de plus de 10 %, de préférence de plus de 20 %, plus particulièrement de préférence de plus de 100 % et
les zones soumises à des chocs, les zones sollicitées mécaniquement ou les zones entrant en contact avec un autre composant comprennent les zones renforcées.

2. Composant micro-mécanique selon la revendication 1, **caractérisé en ce que** la zone renforcée est réalisée au moins sur la partie de l'au moins une surface latérale (2.3, 2.4), qui peut être mise en contact avec un autre composant ou une zone d'un composant.

3. Composant micro-mécanique selon la revendication 1 ou 2, **caractérisé en ce que** le revêtement (6) disposé sur l'au moins une surface latérale (2.3, 2.4) est réalisé avec une épaisseur de couche constante, une épaisseur de couche variable ou un profil d'épaisseur de couche de forme concave.

4. Composant micro-mécanique selon l'une des revendications 1 à 3, **caractérisé en ce que** le composant micro-mécanique (2) présente une section transversale quadrangulaire, de préférence une section transversale rectangulaire et comprend deux surfaces latérales (2.3, 2.4) ainsi qu'un côté supérieur et un côté inférieur (2.5, 2.6).

5. Composant micro-mécanique selon l'une des revendications 1 à 4, **caractérisé en ce qu'**il s'agit d'un composant d'horlogerie sélectionné parmi le groupe constitué de ressorts de traction, d'ancres, de roues d'ancres, de composants d'échappement, de plateaux, de roues dentées, de transmissions, de rubis, d'ardoises, d'axes de pivots ; d'arbres, d'axes, de ressorts, de ressorts de traction, de ressorts de balanciers et/ou de balanciers.

6. Composant micro-mécanique selon la revendication 5 sous la forme d'un ressort de traction pour un barillet d'horlogerie avec une longueur (L) prédéterminée, qui s'étend d'une extrémité interne jusqu'à une extrémité externe du ressort de traction et présente une section transversale quadrangulaire, le revêtement (6) du côté intérieur ou du côté extérieur présentant, sur au moins une partie de la longueur (L) du ressort de traction, une épaisseur de couche supérieure.

7. Composant micro-mécanique selon au moins l'une des revendications 1 à 6, **caractérisé en ce que** le matériau de support est sélectionné dans le groupe constitué de
a) métalloïdes, de préférence du carbone, du silicium ou du germanium ;
b) de matériaux métalliques, de préférence Fe, Ni, Cr, Co, Cu, Mn, V, Ti, Sc, W, Ta, Mo, Nb, Pt, Au, Rh ;
c) d'alliages constitués des matériaux mentionnés au point b) ou
d) de métaux durs, de préférence des carbures métalliques, plus particulièrement le carbure de tungstène.

8. Procédé de fabrication d'un composant micro-mécanique selon au moins l'une des revendications 1 à 7 avec les étapes suivantes :
a) réalisation d'une plaque de substrat constituée d'un matériau de support,
b) structuration du matériau de support à l'aide d'une étape de gravure globalement perpendiculaire à la surface de la plaque de substrat, avec la formation d'un interstice, avec pour condition que la largeur de l'interstice, dans la zone dans laquelle le renforcement doit être réalisé, soit supérieure à celle des autres zones,
c) nucléation du matériau de support avec des produits de départ contenant du carbone pour la formation de germes de diamant et
d) croissance du diamant au moyen d'un traitement laser comme une CVD.

9. Procédé selon la revendication 8, **caractérisé en ce que**, après l'étape d), un traitement de surface avec un plasma est réalisé.

10. Procédé selon la revendication 8 ou 9, **caractérisé en ce que**, en tant qu'étape de gravure, une gravure ionique est employée.

11. Procédé selon au moins l'une des revendications 8 à 10, **caractérisé en ce que**, en tant que plaque de substrat, une tranche de silicium est employée.

12. Procédé selon au moins l'une des revendications 8 à 11, **caractérisé en ce que** le composant micro-mécanique structuré à partir du matériau de support est maintenu à l'aide de nervures dans le substrat.
